# EUROPEAN PATENT APPLICATION

(11) **EP 4 276 896 A1**
(43) Date of publication of application: **15.11.2023**
(21) Application number: 22758907.4
(22) Date of filing: 24.02.2022
(51) Int. Cl.: H01L 23/31, H01L 23/34

(54) **CHIP ENCAPSULATION STRUCTURE AND ELECTRONIC DEVICE**

(30) Priority: 24.02.2021 CN 202110209381
(71) Applicant: Huawei Technologies Co., Ltd., Shenzhen, Guangdong 518129 (CN)
(72) Inventor: WAN, Jun, Shenzhen, Guangdong 518129 (CN)
(74) Representative: Pfenning, Meinig & Partner mbB
(86) International application number: PCT/CN2022/077579
(87) International publication number: WO 2022/179543

(57) **Abstract**

Embodiments of this application disclose a chip package structure and an electronic device, and belong to the field of chip packaging technologies. The chip package structure includes a bare chip, a bare chip carrier, and a package body. The bare chip is located on one side of the bare chip carrier. The package body covers the bare chip to package the bare chip on the bare chip carrier. A recess structure is provided on an outer surface of the package body. The recess structure is configured to increase a heat dissipation area of the package body. The recess structure increases a surface area of the package body, and therefore increases the heat dissipation area of the package body, thereby enhancing a heat dissipation capability of the package body. Regions outside the recess structure can still ensure that the package body has a sufficient structural strength, so that the chip package structure is not prone to damage when subjected to a physical shock.

## Description

### TECHNICAL FIELD

This application relates to the field of chip packaging technologies, and in particular, to a chip package structure and an electronic device.

### BACKGROUND

A packaging process is a process of packaging a bare chip by using an insulation material to form a chip package structure. After the bare chip is packaged, the insulation material isolates the bare chip from the outside, to prevent the bare chip from being corroded by impurities in air, avoid degradation of electrical performance of the bare chip, and prevent the bare chip from an external physical shock.

The bare chip generates a large amount of heat during operation, leading to a temperature rise of the chip package structure. An excessively high temperature reduces stability of the chip package structure, or even causes damage to the chip package structure.

A heat dissipation capability of the chip package structure is affected by a thickness of the insulation material. A thinner insulation material indicates a higher heat dissipation capability of the chip package structure. However, a smaller thickness of the insulation material indicates a lower structural strength of the chip package structure and a lower resistance to an external physical shock. As a result, the chip package structure is prone to damage when subjected to a physical shock.

### SUMMARY

Embodiments of this application provide a chip package structure and an electronic device, to overcome a problem in related technologies that a heat dissipation capability and a structural strength of a chip package structure cannot be balanced. The technical solutions are as follows.

According to a first aspect, a chip package structure is provided. The chip package structure includes a bare chip, a bare chip carrier, and a package body. The bare chip is located on one side of the bare chip carrier. The package body covers the bare chip to package the bare chip on the bare chip carrier. A recess structure is provided on an outer surface of the package body. The recess structure is configured to increase a heat dissipation area of the package body. Based on the foregoing structure, the recess structure increases the heat dissipation area of the package body, thereby enhancing a heat dissipation capability of the package body. Regions outside the recess structure can still ensure that the package body has a sufficient structural strength, so that the chip package structure is not prone to damage when subjected to a physical shock.

In some examples, the recess structure includes a groove. In some other examples, the recess structure includes a hole. In still other examples, the recess structure includes a groove and a hole.

Based on the foregoing structure, an area of the package body in contact with air is increased by at least an area of an inner side wall of the groove or the hole, thereby increasing the heat dissipation area of the package body and enhancing the heat dissipation capability. In addition, the groove and the hole do not reduce an overall thickness of the package body, and regions of the package body that are outside the groove and the hole can still ensure that the package body has a sufficient structural strength, so that the chip package structure is not prone to damage when subjected to a physical shock.

In a possible implementation, the recess structure includes the groove. At least one groove is provided on the outer surface of the package body, and each groove is connected end-to-end and forms a closed pattern.

Based on the foregoing structure, when a vacuum chuck is used to hold the chip package structure, the vacuum chuck can separate a region inside the groove on a top surface of the package body from the atmosphere by completely covering only one groove. In this way, after vacuuming, the chip package structure can be smoothly held by the vacuum chuck.

Optionally, a plurality of grooves are provided on the outer surface of the package body, each groove is connected end-to-end, and the grooves are distributed concentrically. The concentric distribution allows for providing more grooves provided that an area of the outer surface of the package body is fixed, to further improve the heat dissipation capability of the chip package structure, and achieve more uniform heat dissipation on different regions on the outer surface of the package body.

Optionally, the groove forms at least one of a polygon, a rounded polygon, a circle, or an ellipse. The structural strength and the heat dissipation capability of the chip package structure may vary with the pattern formed by the groove. The pattern formed by the groove is selected based on a specific chip package structure, so that both the structural strength and the heat dissipation capability of the chip package structure can meet design requirements. In addition, the groove forming a rounded polygon, a circle, or an ellipse can reduce stress in a local region of the groove, to prevent damage to the package body.

Optionally, a cross section of the groove is in at least one of a rectangular shape, a trapezoidal shape, a semicircular shape, a U shape, or a V shape. Stress distribution in the groove is affected by a shape of the cross section of the groove. When the groove has a semicircular or a U-shaped cross section, stress at a joint between a bottom surface and a side surface is smaller, and the package body is not prone to damage.

In some examples, the recess structure further includes a plurality of holes, and the plurality of holes are distributed around the groove. Both the groove and the holes can increase the heat dissipation area, and the holes can make full use of remaining space on the outer surface of the package body, to further enhance the heat dissipation capability of the chip package structure.

In some examples, the recess structure includes a plurality of holes, and the plurality of holes are distributed in an array. The holes can also increase the heat dissipation area. The holes can be arranged more flexibly than the groove, and the plurality of holes distributed in an array can make heat dissipation of the chip package structure more uniform.

Optionally, the hole is in at least one of a prism shape, a pyramid shape, a frustum shape, a cylindrical shape, a conical shape, a conical frustum shape, or a hemispherical shape. Stress distribution on an inner wall of the hole is affected by a shape of the hole. A hole in a cylindrical shape, a conical shape, a conical frustum shape, or a hemispherical shape has a smoother inner wall with more uniform stress distribution, making the package body less prone to damage due to excessive local stress.

In some examples, the recess structure is located on a top surface of the package body away from the bare chip carrier. The top surface of the package body is a main heat dissipation region. Because an area of the top surface of the package body is usually much larger than an area of a side surface of the package body, it is more convenient to arrange the recess structure on the top surface.

According to a second aspect, an embodiment of this application further provides an electronic device. The electronic device includes a printed circuit board and the chip package structure according to the first aspect. The bare chip carrier is connected to the printed circuit board.

According to a third aspect, an embodiment of this application further provides a packaging mold. The packaging mold includes a first template and a second template. At least one of the first template and the second template has a cavity. A protrusion structure is provided on an inner wall of the cavity. The protrusion structure is configured to form the recess structure according to the first aspect on an outer surface of a package body.

Based on the foregoing structure, during preparation of the package body, a bare chip carrier is placed on the first template. After the second template and the first template are closed, a bare chip is located in a cavity of the second template, and a material for preparing the package body is injected into the cavity, and becomes the package body after curing. Because the protrusion structure is provided on the inner wall of the cavity, the corresponding recess structure is formed on the outer surface of the package body, thereby preparing the chip package structure according to the first aspect.

In a possible implementation, the protrusion structure includes a protruding ridge. At least one protruding ridge is provided on the inner wall of the cavity, and each protruding ridge is connected end-to-end and forms a closed pattern. Based on the foregoing structure, during preparation of the chip package structure, a groove connected end-to-end can be formed on the outer surface of the package body.

Optionally, a plurality of protruding ridges are provided, each protruding ridge is connected end-to-end, and the protruding ridges are distributed concentrically. Based on the foregoing structure, a plurality of grooves each connected end-to-end can be prepared, and the grooves are distributed concentrically.

Optionally, the protruding ridge forms at least one of a polygon, a rounded polygon, a circle, or an ellipse. A pattern formed by the groove formed on the outer surface of the package body varies with a pattern formed by the protruding ridge. A groove in a shape that meets a design requirement can be prepared by selecting a suitable protruding ridge.

Optionally, a cross section of the protruding ridge is in at least one of a rectangular shape, a trapezoidal shape, a semicircular shape, a U shape, or a V shape. Based on the foregoing structure, a groove having a cross section in a rectangular shape, a trapezoidal shape, a semicircular shape, a U shape, or a V shape can be prepared. In addition, a difficulty in demolding during preparation of the chip package structure varies with protruding ridges having different cross sections. A protruding ridge having a cross section in a semicircular shape, a trapezoidal shape, or a V shape allows for easier demolding during preparation, and make the package body less prone to damage.

In some examples, the protrusion structure further includes a protruding column. A plurality of protruding columns are provided on the inner wall of the cavity, and the plurality of protruding columns are distributed around the protruding ridge. With the arrangement of the protruding columns, the holes can be formed on the outer surface of the package body during preparation of the chip package structure. Both the groove and the holes can increase the heat dissipation area, and the formation of the holes outside the groove through the protruding columns can make full use of remaining space on the outer surface of the package body, to further enhance the heat dissipation capability of the chip package structure.

In some examples, the protrusion structure includes a plurality of protruding columns, and the plurality of protruding columns are distributed in an array. In this way, a plurality of holes distributed in an array are formed on the outer surface of the package body. The holes can also increase the heat dissipation area. The holes can be arranged more flexibly than the groove, and the plurality of holes distributed in an array can make heat dissipation of the chip package structure more uniform.

Optionally, the protruding column is in at least one of a prism shape, a pyramid shape, a frustum shape, a cylindrical shape, a conical shape, a conical frustum shape, or a hemispherical shape. A shape of the hole formed on the outer surface of the package body is determined by a shape of the protruding column. A difficulty in demolding during preparation of the chip package structure varies with the shape of the protruding column. A protruding column in a pyramid shape, a frustum shape, a conical shape, a conical frustum shape, or a hemispherical shape allows for easier demolding.

In some examples, the protrusion structure is located on a bottom surface of the cavity.

Based on the foregoing structure, the recess structure can be formed on the top surface of the package body away from the bare chip carrier. The top surface of the package body is a main heat dissipation region. Because an area of the top surface of the package body is usually much larger than an area of a side surface of the package body, it is more convenient to arrange the recess structure on the top surface.

### BRIEF DESCRIPTION OF DRAWINGS

FIG. 1 is a schematic diagram of a chip package structure according to an embodiment of this application;
FIG. 2 is a cross-sectional view taken along line A-A in FIG. 1;
FIG. 3 is a schematic diagram of a chip package structure according to an embodiment of this application;
FIG. 4 is a schematic diagram of a chip package structure according to an embodiment of this application;
FIG. 5 is a schematic diagram of a chip package structure according to an embodiment of this application;
FIG. 6 is a schematic diagram of a chip package structure according to an embodiment of this application;
FIG. 7 is a cross-sectional view taken along line B-B in FIG. 6;
FIG. 8 is a front view of the chip package structure shown in FIG. 1;
FIG. 9 is a schematic diagram of a chip package structure according to an embodiment of this application;
FIG. 10 is a schematic diagram of a chip package structure according to an embodiment of this application;
FIG. 11 is a schematic diagram of a chip package structure according to an embodiment of this application;
FIG. 12 is a schematic diagram of a chip package structure according to an embodiment of this application;
FIG. 13 is a schematic diagram of a chip package structure according to an embodiment of this application;
FIG. 14 is a schematic structural diagram of an electronic device according to an embodiment of this application;
FIG. 15 is a schematic structural diagram of a packaging mold according to an embodiment of this application;
FIG. 16 is a schematic structural diagram of a packaging mold according to an embodiment of this application;
FIG. 17 is a schematic structural diagram of a packaging mold according to an embodiment of this application;
FIG. 18 is a schematic structural diagram of a first template according to an embodiment of this application;
FIG. 19 is a schematic structural diagram of a first template according to an embodiment of this application;
FIG. 20 is a schematic structural diagram of a first template according to an embodiment of this application;
FIG. 21 is a schematic structural diagram of a first template according to an embodiment of this application;
FIG. 22 is a schematic structural diagram of a first template according to an embodiment of this application;
FIG. 23 is a schematic structural diagram of a first template according to an embodiment of this application;
FIG. 24 is a schematic structural diagram of a first template according to an embodiment of this application; and
FIG. 25 is a schematic structural diagram of a first template according to an embodiment of this application.

### Description of reference numerals:

10. bare chip; 100. printed circuit board;
20. bare chip carrier; 21. first pin; 22. second pin; 23. lead; 24. third connection structure; 200. chip package structure;
30. package body; 31. recess structure; 311. groove; 312. hole;
30a. top surface; 30b. side surface; 30c. bottom surface of package body;
40. vacuum chuck;
50. first template; 50a. cavity; 50b. bottom surface; 51. protrusion structure; 511. protruding ridge;
512. protruding column; and
60. second template.

### DESCRIPTION OF EMBODIMENTS

Some terms used in the descriptions of implementations of this application are merely used to explain embodiments of this application, but are not intended to limit this application. Unless otherwise defined, technical terms or scientific terms used in the descriptions of the implementations of this application should have the same meaning as those commonly understood by a person of ordinary skill in the art to which this application pertains. In the specification and claims of this application, terms such as "first", "second", and "third" do not indicate any order, quantity, or importance, but are merely used to distinguish different components. Likewise, terms such as "a/an" and "one" do not indicate a quantity limitation, but means at least one. Terms such as "include" and "comprise" mean that an element or object before the "include" or "comprise" encompasses elements or objects and their equivalents listed after the "include" or "comprise", and other elements or objects are not excluded. Terms such as "connect" and "couple" are not limited to a physical or mechanical connection, but may include an electrical connection, either direct or indirect. Terms such as "up", "down", "left", and "right" are merely used to indicate a relative positional relationship. When an absolute position of an object described changes, the relative positional relationship may also change accordingly.

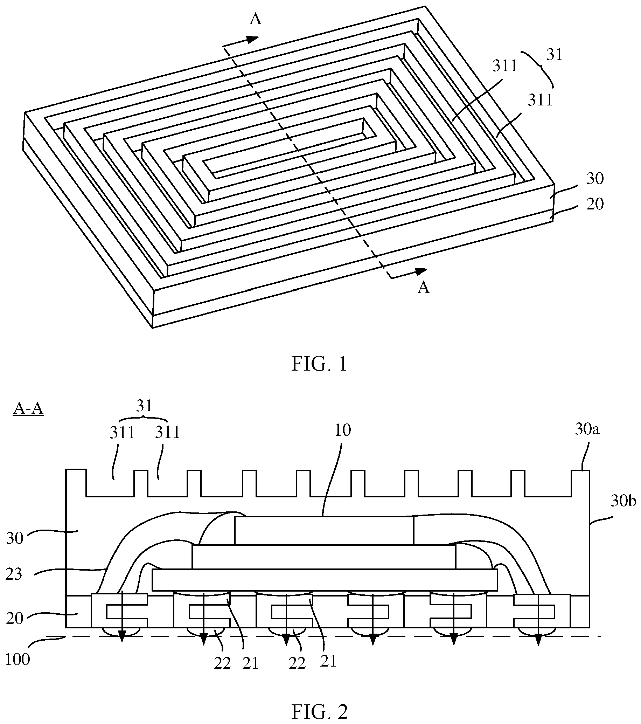

FIG. 1 is a schematic diagram of a chip package structure according to an embodiment of this application. FIG. 2 is a cross-sectional view taken along line A-A in FIG. 1. As shown in FIG. 1 and FIG. 2, the chip package structure includes a bare chip 10, a bare chip carrier 20, and a package body 30. The bare chip 10 is located on one side of the bare chip carrier 20. The package body 30 covers the bare chip 10 to package the bare chip 10 on the bare chip carrier 20. A recess structure 31 is provided on an outer surface of the package body 30. The recess structure 31 is configured to increase a heat dissipation area of the package body 30.

Because the recess structure 31 is provided on the outer surface of the package body 30, the arrangement of the recess structure 31 increases a surface area of the package body 30 compared with a flat outer surface of a package body 30 in related technologies, so that the package body 30 has a larger heat dissipation area, thereby enhancing a heat dissipation capability of the package body 30. Regions outside the recess structure 31 can still ensure that the package body 30 has a sufficient structural strength, so that the chip package structure is not prone to damage when subjected to a physical shock.

For example, in the chip package structure shown in FIG. 1, the recess structure 31 includes a groove 311.

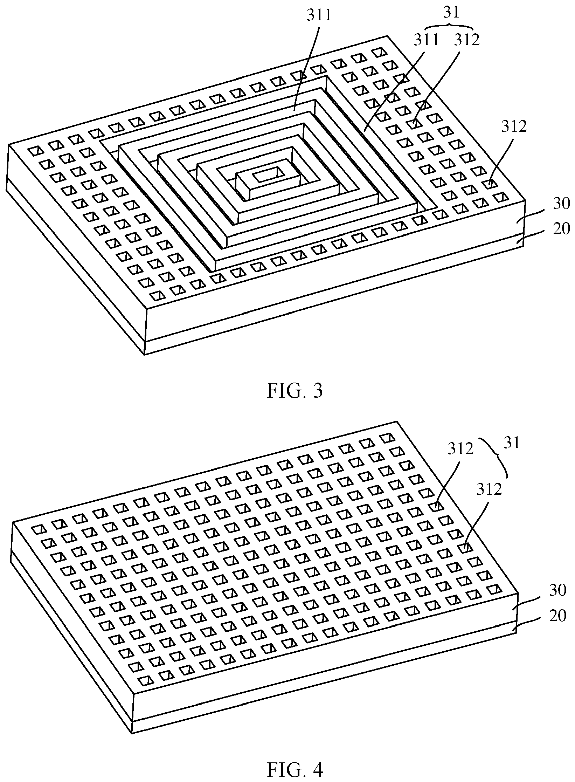

FIG. 3 is a schematic diagram of a chip package structure according to an embodiment of this application. As shown in FIG. 3, in the chip package structure, the recess structure 31 includes a groove 311 and a hole 312.

FIG. 4 is a schematic diagram of a chip package structure according to an embodiment of this application. As shown in FIG. 4, in the chip package structure, the recess structure 31 includes a hole 312.

As shown in FIG. 2, the recess structure 31 is located on a top surface 30a of the package body 30 away from the bare chip carrier 20.

Because an area of the top surface 30a of the package body 30 is usually much larger than an area of a side surface 30b of the package body 30, it is more convenient to arrange the recess structure 31 on the top surface 30a.

FIG. 1 to FIG. 4 merely illustrates an example in which the recess structure 31 is located on the top surface 30a, and this does not mean that the recess structure 31 can only be arranged on the top surface 30a of the package body 30. In some other examples, the recess structure 31 may be located on the side surface 30b of the package body 30, or the recess structure 31 may be partially located on the top surface 30a of the package body 30 and partially located on the side surface 30b of the package body 30.

Optionally, the bare chip carrier 20 is a package substrate or a lead frame.

For example, in FIG. 1 to FIG. 4, the bare chip carrier 20 is a package substrate. As shown in FIG. 2, a first pin 21 is provided on one side of the package substrate, and a second pin 22 is provided on another side of the package substrate. The first pin 21 and the second pin 22 are connected to each other inside the package substrate. The bare chip 10 is located on one side of the package substrate. The bare chip 10 is soldered to the first pin 21 on a surface of the package substrate. The bare chip 10 is further connected to the package substrate through a lead 23, for example, a metal lead, usually a gold wire.

The second pin 22 of the package substrate is configured to connect to a printed circuit board. When the chip package structure is connected to the printed circuit board, the second pin 22 of the package substrate is soldered to the printed circuit board.

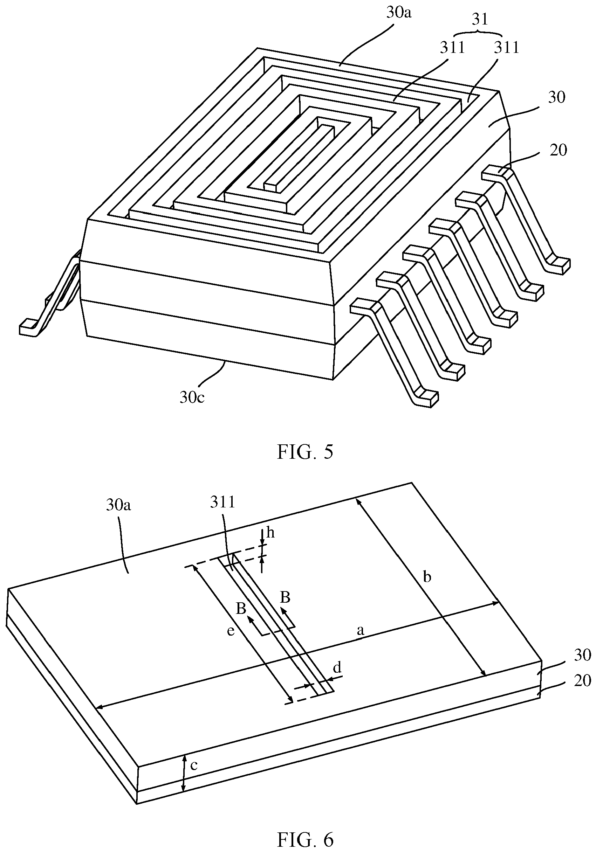

FIG. 5 is a schematic diagram of a chip package structure according to an embodiment of this application. As shown in FIG. 5, in the chip package structure, the bare chip carrier 20 is a lead frame. A plurality of pins of the lead frame are bent toward a same side, and a recess structure 31 is provided on the top surface 30a of the package body 30 away from the pins of the lead frame. In some examples, a recess structure 31 is also provided on a package body bottom surface 30c of the package body 30 opposite to the top surface 30a. After the chip package structure in which the bare chip carrier 20 is the lead frame is mounted on a printed circuit board, a gap between the bottom surface 30c of the package body 30 and the printed circuit board is very small. However, the recess structure 31 provided on the bottom surface 30c of the package body 30 can also increase the heat dissipation area.

Heat dissipation of the chip package structure is usually implemented through two heat dissipation paths. According to a first heat dissipation path, the heat dissipation is implemented through the bare chip carrier 20. According to a second heat dissipation path, the heat dissipation is implemented through the outer surface of the package body 30 to directly dissipate heat to air.

In FIG. 2, an arrow is used to schematically show a heat transfer direction according to the first heat dissipation path. As shown in FIG. 2, heat is conducted by the second pin 22 from the chip package structure to a printed circuit board 100 connected to the chip package structure, and then the heat is dissipated to an external environment through the printed circuit board 100. Pins of the chip package structure are metal structures having a high heat conduction capability. For example, a pin made of copper has a thermal conductivity of up to 398 W/(m·K), allowing the chip package structure to dissipate heat rapidly. However, because a quantity of pins of the chip package structure is limited and an amount of heat generated by the chip package structure increases along with the development of technologies, the first heat dissipation path alone cannot completely meet a heat dissipation requirement, and the second heat dissipation path is also required for assistance.

FIG. 6 is a schematic diagram of a chip package structure according to an embodiment of this application. For ease of comparison, in the chip package structure, the package body 30 has only one groove 311, and the groove 311 has a length e, a width d, and a depth h. As shown in FIG. 6, a package size of the chip package structure is a×b×c, and the heat dissipation area of the package body, to be specific, an area of the package body in contact with air, is a sum of areas of the top surface of the package body, four side surfaces of the chip package structure, and an inner side wall of the groove 311, that is, a×b+2a×c+2b×c+2e×h+2d×h. For a chip package structure having the same package size in related technologies, the heat dissipation area of the package body is a sum of areas of the top surface of the package body and four side surfaces of the chip package structure, that is, a×b+2a×c+2b×c. Compared with a chip package structure in related technologies, in this embodiment of this application, the area of the package body 30 in contact with air is increased by at least an area of an inner side wall of the groove 311 or the hole 312, thereby enhancing the heat dissipation capability of the package body 30. In addition, the groove 311 and the hole 312 do not reduce an overall thickness of the package body 30, and regions of the package body 30 that are outside the groove 311 and the hole 312 can still ensure that the package body 30 has a sufficient structural strength, so that the chip package structure is not prone to damage when subjected to a physical shock.

A more intuitive example is provided below to describe an effect of the recess structure 31 in improving a heat dissipation capability of the chip package structure.

If a=11 mm, b=7 mm, and c=0.8 mm, a heat dissipation area of a package body in a chip package structure having a package size of 11 mm×7 mm×0.8 mm in related technologies is only 105.8 mm². In the chip package structure shown as an example in FIG. 6, neither the groove 311 nor the hole 312 is provided on a side wall of the package body 30. Therefore, a heat dissipation effect of the side wall of the chip package structure is ignored, and only a heat dissipation effect of the top surface of the package body 30 is considered. In this case, the heat dissipation area of the package body in the chip package structure having the package size of 11 mm × 7 mm × 0.8 mm in related technologies is the area of the top surface of the package body 30, that is, 77 mm².

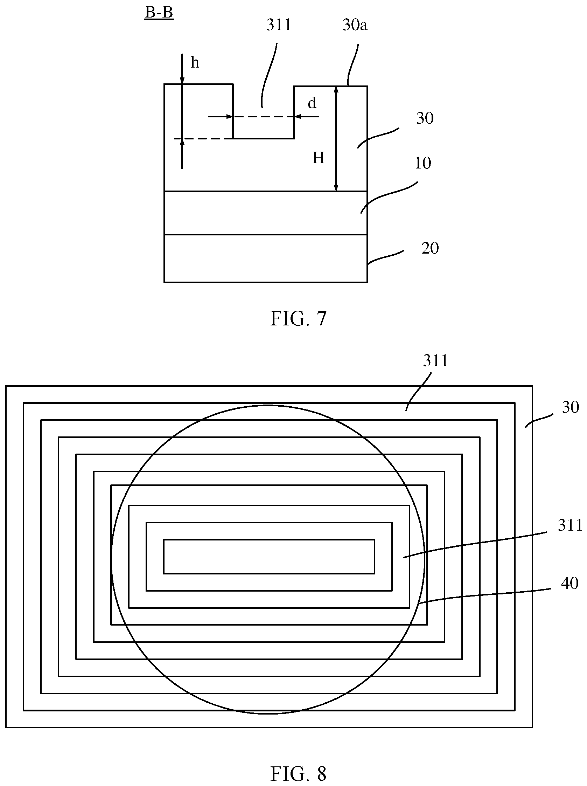

FIG. 7 is a cross-sectional view taken along line B-B in FIG. 6. As shown in FIG. 6 and FIG. 7, in this embodiment of this application, e=5 mm, d=0.1 mm, h=0.1 mm, and a vertical distance H between the top surface 30a of the package body 30 and the bare chip 20 is 0.2 mm.

The heat dissipation area is increased by areas of four inner side walls of the groove 311, that is, is increased by 1.02 mm² in total.

A length of a path for conducting heat from the bare chip 10 to the top surface 30a of the package body 30 is H, and a path for conducting heat from the bare chip 10 to the inner side walls of the groove 311 is shorter than the path for conducting heat from the bare chip 10 to the top surface 30a of the package body 30. A shorter heat conduction path indicates a higher heat dissipation rate. Lengths of paths for conducting heat from the bare chip 10 to different regions on the inner side walls of the groove 311 are different. However, the lengths of the paths can be equivalent to a vertical distance from half the depth of the groove 311 to the bare chip 10, that is, H-0.5h. A ratio of a heat dissipation rate of the inner side wall of the groove 311 to a heat dissipation rate of a region having the same area on the top surface 30a of the package body 30 is H/(H-0.5h), which is 1.33. Based on this ratio and the areas of the inner side walls of the groove 311, it can be determined that a heat dissipation capability of the inner side walls of the groove 311 is equivalent to a heat dissipation capability of a region having an area of 1.36 mm² on the top surface 30a of the package body 30.

A ratio of a heat dissipation rate of a groove bottom of the groove 311 to a heat dissipation rate of a region having the same area on the top surface 30a of the package body 30 is H/H-h, which is 2. Based on this ratio and an area of the groove bottom of the groove 311, it can be determined that a heat dissipation capability of the groove bottom of the groove 311 is equivalent to a heat dissipation capability having of a region having an area of 1 mm² on the top surface 30a of the package body 30.

It can be learned that a heat dissipation capability provided by the one groove 311 shown in FIG. 6 is equivalent to a heat dissipation capability of a region having an area of 2.36 mm² on the top surface 30a of the package body 30, and an area occupied by the groove 311 on the top surface 30a of the package body 30 is 0.5 mm². Therefore, the arrangement of the groove 311 on the top surface 30 of the package body 30 is equivalent to increasing the area of the top surface 30a of the package body 30 by 1.86 mm². The heat dissipation capability of the package body 30 can be greatly improved by providing a plurality of grooves 311. Because the heat dissipation capability of the package body 30 is affected by the length, width, and depth of the groove 311 and a quantity of grooves 311, the heat dissipation capability of the package body 30 can be enhanced by increasing the length, width, or depth of the groove 311 or increasing the quantity of grooves 311.

FIG. 8 is a front view of the chip package structure shown in FIG. 1. As shown in FIG. 8, the recess structure 31 includes grooves 311, and each groove 311 is connected end-to-end and forms a closed pattern.

During production, the chip package structure is usually picked up and placed using a holding tool such as a vacuum chuck or a vacuum pen. The holding tool is usually attached to the top surface 30a of the package body 30. Each groove 311 is designed to be in an end-to-end connected form, and each groove 311 forms a closed pattern. Using a vacuum chuck 40 as an example, the vacuum chuck 40 can separate a region inside one groove 311 on the top surface 30a of the package body 30 from the atmosphere by covering the groove 311. In this way, after vacuuming, the chip package structure can be smoothly held by the vacuum chuck 40, thereby meeting a requirement for automated transfer of the chip package structure in a production line.

Optionally, the groove 311 forms at least one of a polygon, a rounded polygon, a circle, or an ellipse. For example, the polygon includes a triangle, a rectangle, and a rhomboid. The rounded polygon includes a rounded triangle, a rounded rectangle, and a rounded rhomboid.

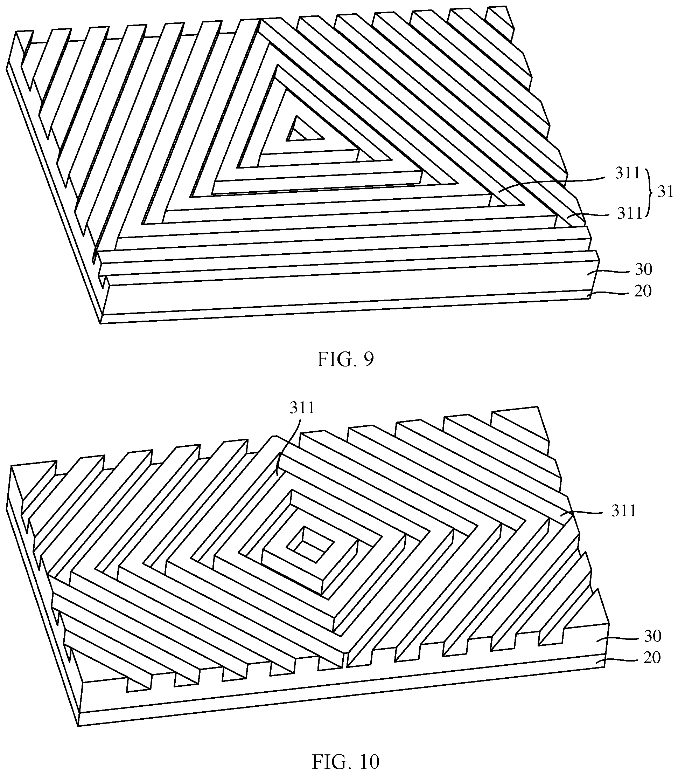

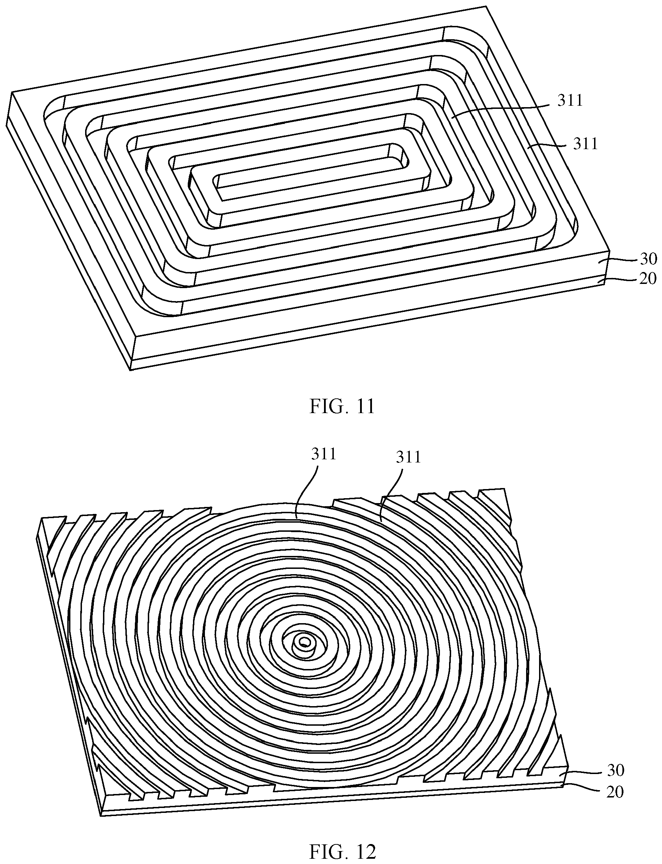

For example, in the chip package structure shown in FIG. 1, the groove 311 forms a rectangle. FIG. 9 is a schematic diagram of a chip package structure according to an embodiment of this application. As shown in FIG. 9, in the chip package structure, the groove 311 forms a triangle. FIG. 10 is a schematic diagram of a chip package structure according to an embodiment of this application. As shown in FIG. 10, in the chip package structure, the groove 311 forms a rhomboid. FIG. 11 is a schematic diagram of a chip package structure according to an embodiment of this application. As shown in FIG. 11, in the chip package structure, the groove 311 forms a rounded rectangle. FIG. 12 is a schematic diagram of a chip package structure according to an embodiment of this application. As shown in FIG. 12, in the chip package structure, the groove 311 forms a circle.

The structural strength and the heat dissipation capability of the chip package structure may vary with the pattern formed by the grooves 311. The pattern formed by the grooves 311 is selected based on a specific chip package structure, so that both the structural strength and the heat dissipation capability of the chip package structure can meet design requirements. For example, a shape formed by the groove 311 is consistent with a shape of the top surface 30a of the package body 30.

When the chip package structure generates heat, high stress is likely to be generated at a corner of the groove 311 due to thermal expansion and contraction of the package body 30 caused by a temperature change. When the chip package structure is subjected to an external physical shock, high stress is also likely to be generated at a corner of the groove 311. The groove 311 forming a rounded polygon can reduce stress in a local region of the package body 30, to prevent the package body 30 from being damaged due to excessive local stress. The groove 311 forming a circle can reduce the local stress to the greatest extent.

As shown in FIG. 12, a plurality of grooves 311 are provided, each groove 311 is connected end-to-end, and the grooves are distributed concentrically. The concentric distribution of the grooves 311 means that geometric centers of patterns formed by different grooves 311 coincide, and after the patterns formed by the different grooves 311 are separately scaled up or down without rotation, the patterns can overlap. For example, in FIG. 12, patterns formed by the plurality of grooves 311 form a set of concentric circles.

The arrangement of the plurality of grooves 311 in the concentrically distributed manner allows for providing more grooves 311 provided that an area of the outer surface of the package body 30 is fixed, to further improve the heat dissipation capability of the chip package structure. In addition, with the concentric distribution, heat dissipation capabilities of different regions on the outer surface of the package body 30 are closer, to make heat dissipation of the chip package structure more uniform, thereby avoiding excessively high temperature of a local region caused by non-uniform heat dissipation of the chip package structure.

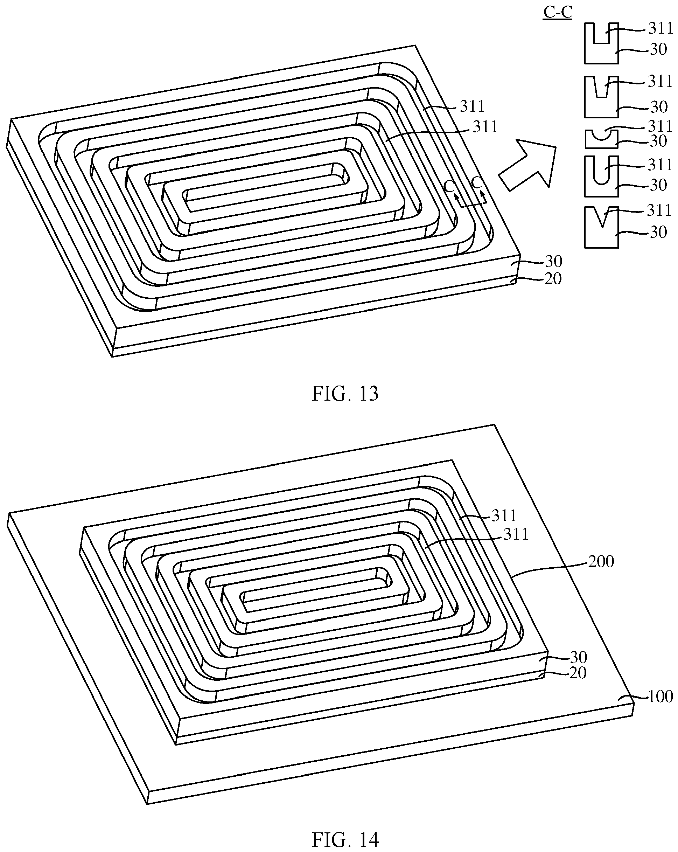

FIG. 13 is a schematic diagram of a chip package structure according to an embodiment of this application, where a cross section of the groove 311 is shown. As shown by a cross section C-C in FIG. 13, the cross section of the groove 311 is in at least one of a rectangular shape, a trapezoidal shape, a semicircular shape, a U shape, or a V shape.

Stress distribution at a joint between a bottom surface and a side surface of the groove 311 varies with the cross section of the groove 311. When the groove 311 has a semicircular or a U-shaped cross section, stress at the joint between the bottom surface and the side surface is smaller, and the package body 30 is less prone to damage.

The package body 30 is usually prepared using a mold. A difficulty in preparing the package body 30 varies with the cross section of the groove 311. A groove 311 having a cross section in a semicircular shape, a trapezoidal shape, or a V shape allows for easier demolding during preparation.

Referring to FIG. 3, the recess structure 31 includes a groove 311 and a hole 312. A plurality of holes 312 are provided, and the plurality of holes 312 are distributed around the groove 311.

When the outer surface of the package body 30 cannot be fully used for providing the groove 311, the holes 312 are arranged around the groove 311 to further increase the heat dissipation area. For example, when the shape formed by the groove 311 is different from the shape of the top surface 30a of the package body 30, there is some space left around the groove 311 on the top surface 30a of the package body 30. The holes 312 can be arranged more flexibly. The arrangement of the holes 312 fully uses the remaining space on the outer surface of the package body 30 to increase the heat dissipation area.

Optionally, the plurality of holes 312 are distributed in an array. The holes 312 distributed in an array can make heat dissipation of different regions on the outer surface of the package body 30 more uniform, thereby avoiding excessively high temperature of a local region caused by non-uniform heat dissipation of the chip package structure.

Optionally, the hole 312 is in at least one of a prism shape, a pyramid shape, a frustum shape, a cylindrical shape, a conical shape, a conical frustum shape, or a hemispherical shape.

Stress distribution of an inner wall of the hole 312 varies with the shape of the hole 312. A hole 312 in a prism shape, a pyramid shape, or a frustum shape has high stress at joints between sides on the inner wall, and stress distribution is not uniform on the inner wall. A hole in a cylindrical shape, a conical shape, a conical frustum shape, or a hemispherical shape has a smoother inner wall with more uniform stress distribution, making the package body 30 less prone to damage due to excessive local stress.

In addition, when the package body 30 is prepared using a mold, a hole 312 in a pyramid shape, a frustum shape, a conical shape, a conical frustum shape, or a hemispherical shape allows for easier demolding.

Optionally, a material for preparing the package body 30 is an epoxy resin, a ceramic, or a metal. A package type of the chip package structure usually includes a resin package, a ceramic package, and a metal package. Different materials are selected for preparing the package body 30 based on different package types, so that the chip package structure meets a corresponding design requirement.

FIG. 14 is a schematic structural diagram of an electronic device according to an embodiment of this application. As shown in FIG. 14, the electronic device includes a printed circuit board 100 and a chip package structure 200, and a bare chip carrier 20 is connected to the printed circuit board 100. The chip package structure 200 is any chip package structure shown in FIG. 1 to FIG. 13.

A recess structure 31, either a groove 311 or a hole 312, is provided on an outer surface of the package body 30. Compared with a chip package structure in related technologies, an area of the package body 30 in contact with air is increased by at least an area of a side wall of the groove 311 or the hole 312, thereby increasing a heat dissipation area of the package body 30 and enhancing a heat dissipation capability of the package body 30. In addition, the groove 311 and the hole 312 do not reduce an overall thickness of the package body 30, and regions of the package body 30 that are outside the groove 311 and the hole 312 can still ensure that the package body 30 has a sufficient structural strength, so that the chip package structure is not prone to damage when subjected to a physical shock.

During preparation of the chip package structure, a bare chip 10 is first connected to the bare chip carrier 20. Then, the bare chip carrier 20 and the bare chip 10 are placed in a packaging mold, and the package body 30 is prepared using the packaging mold. After the mold is opened, the prepared chip package structure can be taken out from the packaging mold. After the chip package structure is taken out from the packaging mold, various identifiers such as a brand identifier may be formed on a top surface 30a of the package body 30 by laser printing.

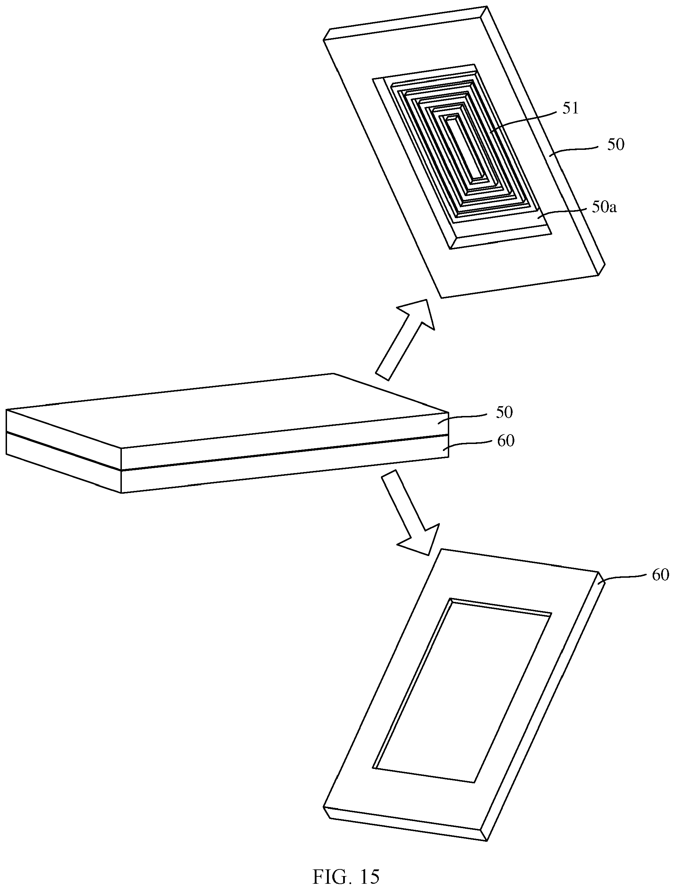

FIG. 15 is a schematic structural diagram of a packaging mold according to an embodiment of this application. As shown in FIG. 15, the packaging mold includes a first template 50 and a second template 60. At least one of the first template 50 and the second template 60 has a cavity 50a. A protrusion structure 51 is provided on an inner wall of the cavity 50a. The protrusion structure 51 is configured to form a recess structure 31 on an outer surface of a package body 30. The recess structure 31 is configured to increase a heat dissipation area of the package body 30. The recess structure 31 includes at least one of a groove 311 and a hole 312. For a specific structure of the recess structure 31, refer to any chip package structure shown in FIG. 1 to FIG. 13.

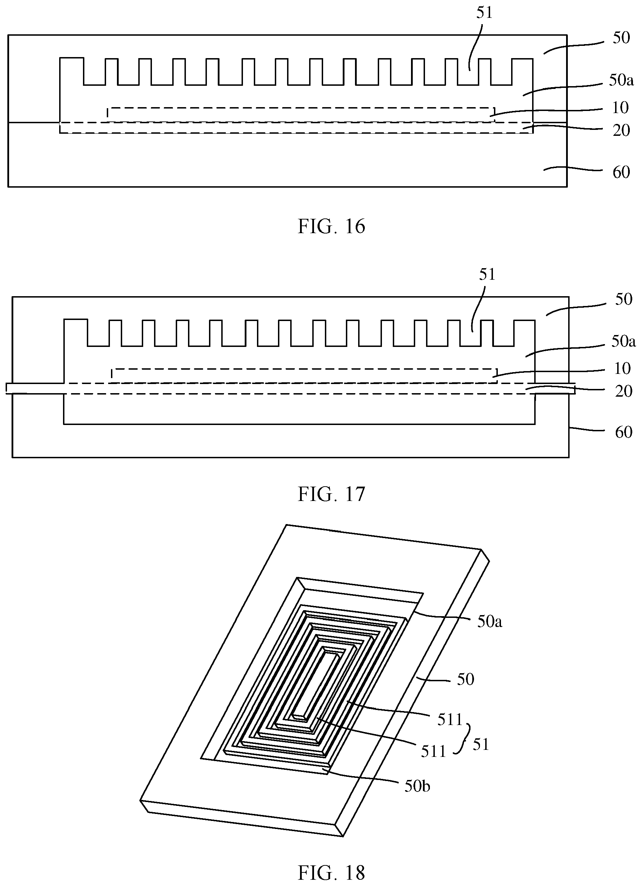

FIG. 16 is a schematic structural diagram of a packaging mold according to an embodiment of this application. The packaging mold is configured to prepare a chip package structure in which a bare chip carrier 20 is a package substrate. In the first template 50 and the second template 60, the first template 50 has a cavity 50a. Using the packaging mold shown in FIG. 16 as an example, during preparation of the package body 30, the bare chip carrier 20 is placed on the second template 60. After the first template 50 and the second template 60 are closed, a bare chip 10 is located in the cavity 50a of the first template 50, and a material for preparing the package body 30 is injected into the cavity 50a, and becomes the package body 30 after curing. Because the protrusion structure 51 is provided on the inner wall of the cavity 50a, the corresponding recess structure 31 is formed on the outer surface of the package body 30.

FIG. 17 is a schematic structural diagram of a packaging mold according to an embodiment of this application. The packaging mold is configured to prepare a packaging mold in which a bare chip carrier 20 is a lead frame. In the packaging mold, the first template 50 and the second template 60 each have a cavity 50a. A protrusion structure 51 is provided on an inner wall of one of the two cavities 50a. In some other examples, a protrusion structure 51 is provided on an inner wall of each of the two cavities 50a. In this way, during preparation of the chip package structure shown in FIG. 5 in which the bare chip carrier 20 is a lead frame, a recess structure 31 can be formed on each of two opposite surfaces of the package body 30, to further increase the heat dissipation area.

FIG. 18 is a schematic structural diagram of a first template according to an embodiment of this application. As shown in FIG. 18, the protrusion structure 51 is located on a bottom surface 50b of the cavity 50a.

Because an area of the top surface 30a of the package body 30 is usually much larger than an area of a side surface 30b of the package body 30, it is more convenient to arrange the recess structure 31 on the top surface 30a. Therefore, with the arrangement of the protrusion structure 51 on the bottom surface 50b of the cavity 50a, the recess structure 31 can be formed on the top surface 30a of the package body 30.

As shown in FIG. 18, the protrusion structure 51 includes protruding ridges 511, and each protruding ridge 511 is connected end-to-end and forms a closed pattern.

The protruding ridge 511 connected end-to-end can cause the groove 311 formed on the surface of the package body 30 to be connected end-to-end and to form a closed pattern. When a vacuum chuck is used to hold the chip package structure, the vacuum chuck can separate a region inside the groove 311 on the top surface 30a of the package body 30 from the atmosphere by covering the groove 311. After vacuuming, the chip package structure can be smoothly held, thereby meeting a requirement for automated transfer of the chip package structure in a production line.

Optionally, the protruding ridge 511 forms at least one of a polygon, a rounded polygon, a circle, or an ellipse. For example, the polygon includes a triangle, a rectangle, and a rhomboid. The rounded polygon includes a rounded triangle, a rounded rectangle, and a rounded rhomboid.

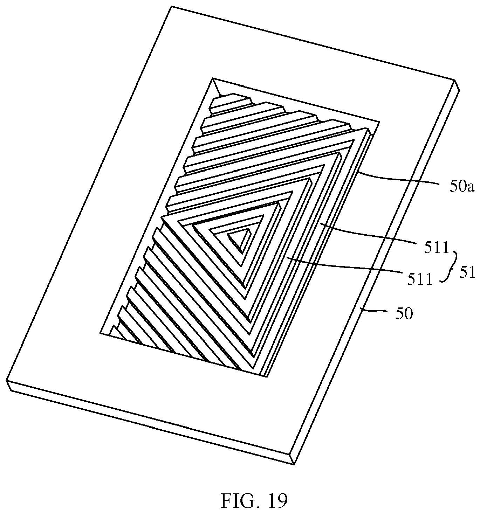

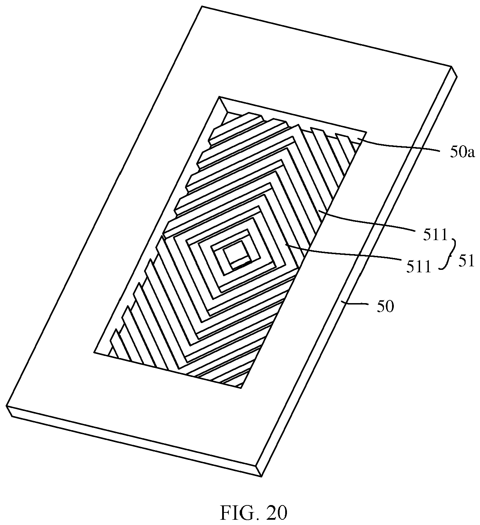

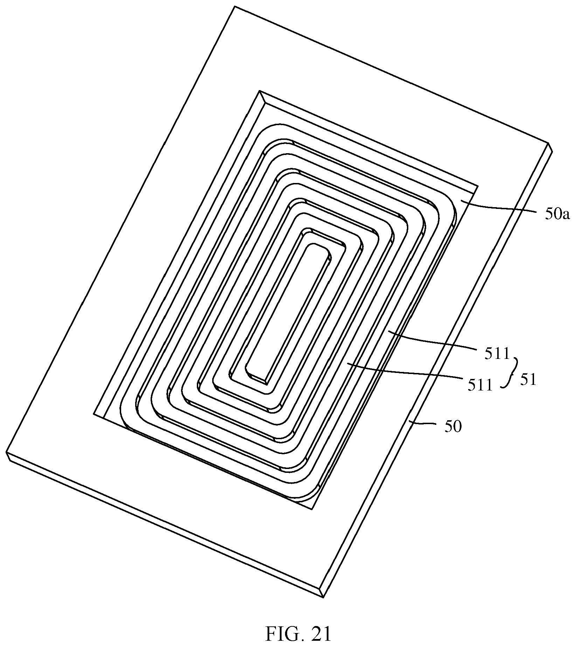

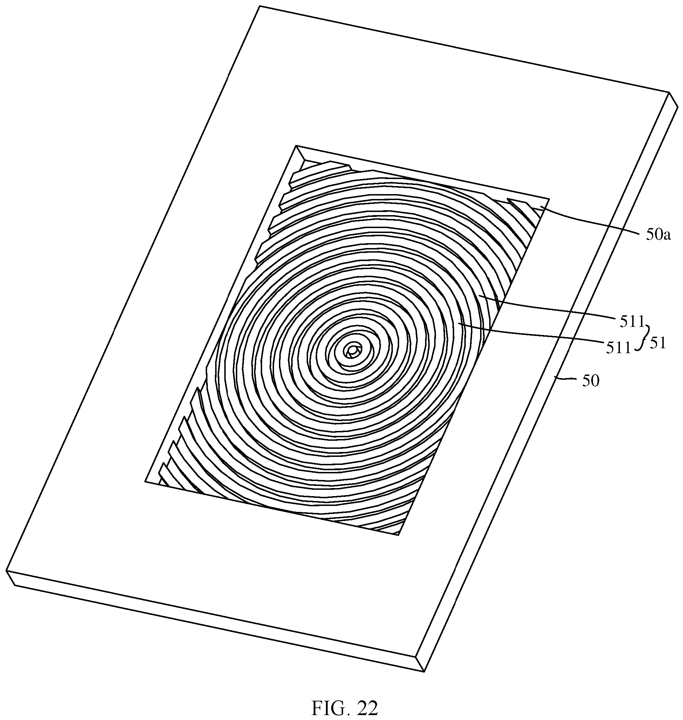

For example, as shown in FIG. 18, the protruding ridge 511 forms a rectangle. FIG. 19 is a schematic structural diagram of a first template according to an embodiment of this application. As shown in FIG. 19, in the first template 50, the protruding ridge 511 forms a triangle. FIG. 20 is a schematic structural diagram of a first template according to an embodiment of this application. As shown in FIG. 20, in the first template 50, the protruding ridge 511 forms a rhomboid. FIG. 21 is a schematic structural diagram of a first template according to an embodiment of this application. As shown in FIG. 21, in the first template 50, the protruding ridge 511 forms a rounded rectangle. FIG. 22 is a schematic structural diagram of a first template according to an embodiment of this application. As shown in FIG. 22, in the first template 50, the protruding ridge 511 forms a circle.

The structural strength and the heat dissipation capability of the chip package structure may vary with the pattern formed by the grooves 311. The pattern formed by the grooves 311 is selected based on a specific chip package structure, so that both the structural strength and the heat dissipation capability of the chip package structure can meet design requirements. The shape formed by the groove 311 formed on the outer surface of the package body 30 is consistent with a shape formed by the protruding ridge 511 in the packaging mold. A packaging mold having a suitable protruding ridge 511 is selected based on the groove 311 to be prepared.

As shown in FIG. 22, a plurality of protruding ridges 511 are provided, each protruding ridge 511 is connected end-to-end, and the protruding ridge are distributed concentrically. The concentric distribution of the protruding ridges 511 means that geometric centers of patterns formed by different protruding ridges 511 coincide, and after the patterns formed by the different protruding ridges 511 are separately scaled up or down without rotation, the patterns can overlap.

For example, in FIG. 22, patterns formed by the protruding ridges 511 form a set of concentric circles. With the arrangement of the plurality of protruding ridges 511 distributed concentrically, a plurality of grooves 311 distributed concentrically can be formed on the outer surface of the package body 30.

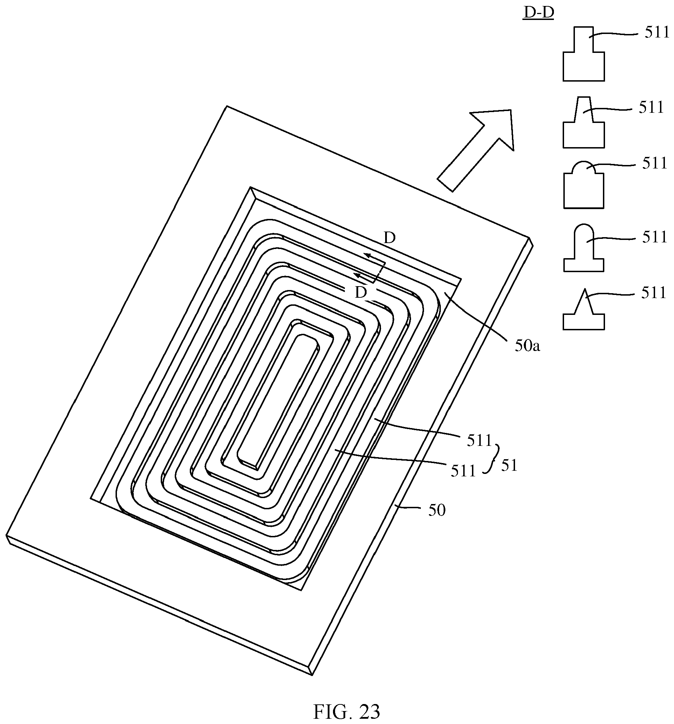

FIG. 23 is a schematic structural diagram of a first template according to an embodiment of this application, where a cross section of the protruding ridge 511 is shown. As shown by a cross section D-D in FIG. 23, the cross section of the protruding ridge 511 is in at least one of a rectangular shape, a trapezoidal shape, a semicircular shape, a U shape, or a V shape.

A cross section of the groove 311 prepared on the outer surface of the package body 30 is determined by the cross section of the protruding ridge 511. A difficulty in demolding during preparation of the chip package structure varies with the cross section of the protruding ridge 511. Compared with a protruding ridge 511 having a cross section in a rectangular shape or a V shape, a protruding ridge 511 having a cross section in a semicircular shape, a trapezoidal shape, or a V shape allows for easier demolding during preparation of the chip package structure.

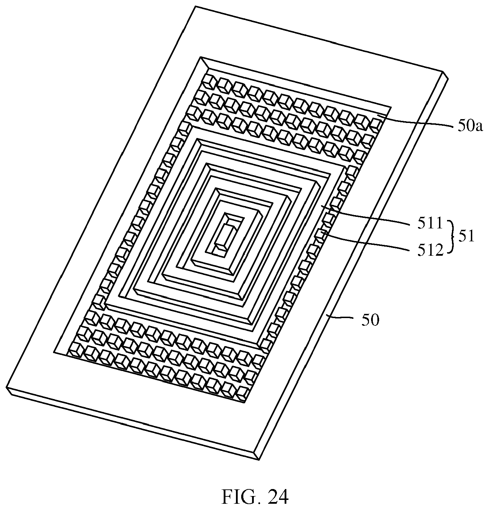

FIG. 24 is a schematic structural diagram of a first template according to an embodiment of this application. As shown in FIG. 24, the protrusion structure 51 includes a protruding ridge 511 and a protruding column 512. A plurality of protruding columns 512 are provided, and the plurality of protruding columns 512 are distributed around the protruding ridge 511. The protruding columns 512 are configured to form the holes 312 on the outer surface of the package body 30. The plurality of protruding columns 512 distributed around the protruding ridges 511 can form, on the outer surface of the package body 30, a plurality of holes 312 distributed around the grooves 311, so that a recess structure is disposed by full use of the outer surface of the package body 30, and heat dissipation area of a chip package structure is increased.

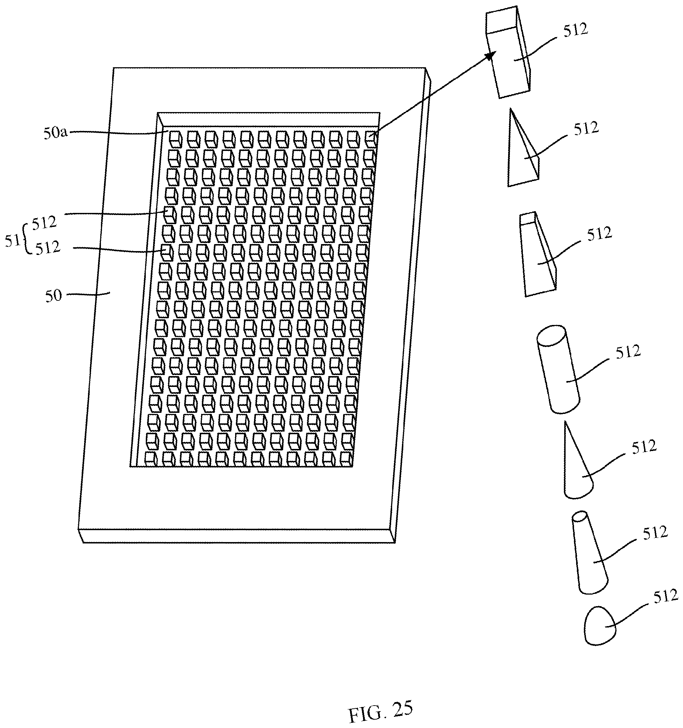

FIG. 25 is a schematic structural diagram of a first template according to an embodiment of this application. As shown in FIG. 25, the protrusion structure 51 includes a plurality of protruding columns 512, and the plurality of protruding columns 512 are distributed in an array. With the protruding columns 512 distributed in an array, holes 312 distributed in an array can be formed on the outer surface of the package body 30, to make heat dissipation of different regions on the outer surface of the package body 30 more uniform, thereby avoiding excessively high temperature of a local region caused by non-uniform heat dissipation of the chip package structure.

A plurality of protruding columns 512 in different shapes are shown in FIG. 25. As shown in FIG. 25, the protruding column 512 is in at least one of a prism shape, a pyramid shape, a frustum shape, a cylindrical shape, a conical shape, a conical frustum shape, or a hemispherical shape.

A shape of the hole 312 formed on the outer surface of the package body 30 is determined by a shape of the protruding column 512. A difficulty in demolding during preparation of the chip package structure varies with the shape of the protruding column 512. Compared with a protruding column 512 in a prism shape or a cylindrical shape, a protruding column 512 in a pyramid shape, a frustum shape, a conical shape, a conical frustum shape, or a hemispherical shape allows for easier demolding during preparation of the chip package structure.

The foregoing descriptions are merely embodiments of this application, but are not intended to limit this application. Any modification, equivalent replacement, or improvement made within the spirit or principle of this application should fall within the protection scope of this application.

## Claims

1. A chip package structure, comprising a bare chip (10), a bare chip carrier (20), and a package body (30), wherein
the bare chip (10) is located on one side of the bare chip carrier (20); and
the package body (30) covers the bare chip (10) to package the bare chip (10) on the bare chip carrier (20), a recess structure (31) is provided on an outer surface of the package body (30), and the recess structure (31) is configured to increase a heat dissipation area of the package body (30).

2. The chip package structure according to claim 1, wherein the recess structure (31) comprises at least one groove (311), and each groove (311) is connected end-to-end and forms a closed pattern.

3. The chip package structure according to claim 2, wherein a plurality of grooves (311) are provided, and each groove (311) is connected end-to-end, and the grooves are distributed concentrically.

4. The chip package structure according to claim 2 or 3, wherein the groove (311) forms at least one of a polygon, a rounded polygon, a circle, or an ellipse.

5. The chip package structure according to any one of claims 2 to 4, wherein a cross section of the groove (311) is in at least one of a rectangular shape, a trapezoidal shape, a semicircular shape, a U shape, or a V shape.

6. The chip package structure according to any one of claims 2 to 5, wherein the recess structure (31) further comprises a plurality of holes (312), and the plurality of holes (312) are distributed around the groove (311).

7. The chip package structure according to claim 1, wherein the recess structure (31) comprises a plurality of holes (312), and the plurality of holes (312) are distributed in an array.

8. The chip package structure according to claim 6 or 7, wherein the hole (312) is in at least one of a prism shape, a pyramid shape, a frustum shape, a cylindrical shape, a conical shape, a conical frustum shape, or a hemispherical shape.

9. The chip package structure according to any one of claims 1 to 8, wherein the recess structure (31) is located on a top surface (30a) of the package body (30) away from the bare chip carrier (20).

10. An electronic device, comprising a printed circuit board (100) and the chip package structure (200) according to any one of claims 1 to 9, wherein the bare chip carrier (20) is connected to the printed circuit board (100).
